# EUROPÄISCHE PATENTSCHRIFT

(11) **EP 2 369 609 B1**
(45) Veröffentlichungstag und Bekanntmachung des Hinweises auf die Patenterteilung: **23.09.2015**
(21) Anmeldenummer: 11001447.9
(22) Anmeldetag: 22.02.2011
(51) Int. Cl.: H01H 59/00, B81B 3/00, H01P 1/12, H02N 1/00, H01G 5/16

(54) **HF-MEMS-Schalter**
HF-MEMS switch
Commutateur HF-MEMS

(30) Priorität: 24.03.2010 DE 102010012607
(43) Veröffentlichungstag der Anmeldung: 28.09.2011
(73) Patentinhaber: Airbus Defence and Space GmbH, 85521 Ottobrunn (DE)
(72) Erfinder: Ziegler, Volker, 85579 Neubiberg (DE); Schönlinner, Bernhard, 81547 München (DE); Prechtel, Ulrich, 81739 München (DE); Stehle, Armin, 89231 Neu-Ulm (DE)
(74) Vertreter: Rasch, Michael

(56) Entgegenhaltungen:
- US-A1- 2004 157 364
- RALUCA MÜLLER ET AL: "Tunable Fabry-Perot surface micromachined interferometer-experiments and modeling", MICROSYSTEM TECHNOLOGIES ; MICRO AND NANOSYSTEMS INFORMATION STORAGE AND PROCESSING SYSTEMS, SPRINGER, BERLIN, DE, Bd. 12, Nr. 1-2, 1. Dezember 2005 (2005-12-01), Seiten 91-97, XP019349512, ISSN: 1432-1858, DOI: 10.1007/S00542-005-0021-Y

## Beschreibung

Die Erfindung betrifft einen Hochfrequenz-MEMS-Schalter mit einem biegbaren Schaltelement, dessen festes Ende auf einem mit einem Isolator versehenen hochresistiven Substrat angebracht ist, wobei das Substrat ferner einen Signalleiter umfasst, das mit dem bewegbaren Ende des Schaltelements in dessen unterer Endstellung eine kapazitive Kopplung ausbildet, ferner mit einer Kontaktelektrode zur Zuführung von Ladungsträgern in das Substrat, wobei zwischen Schaltelement und Substrat ein elektrisches Feld zur Erzeugung einer elektrostatischen Biegekraft auf das Schaltelement erzeugbar ist, gemäß dem Oberbegriff von Patentanspruch 1.

MEMS-Schalter (MEMS = Micro Electromechanical Systems) kommen in den verschiedensten Bereichen zur Anwendung, insbesondere der Automobilelektronik, Telekommunikation, Medizintechnik oder Messtechnik. Aufgrund ihrer Miniaturisierung sind derartige als mikroelektromechanische Systeme ausgestaltete Schaltelemente besonders auch für Raumfahrtanwendungen und Satellitensysteme geeignet. Insbesondere auch in Radarsystemen, Satelliten Kommunikationssystemen, drahtlosen Kommunikationssystemen und Instrumentensystemen kommen Hochfrequenz-MEMS-Schalter zum Einsatz. Beispiele dafür sind Phasenantennenanlagen und Phasenschieber für satellitenbasierte Radarsysteme.

Hochfrequenz-MEMS-Schalter bieten eine Reihe von Vorzügen, wie insbesondere einen sehr geringen Stromverbrauch, eine gute Isolation bzw. geringe Störkapazitäten, eine geringe Einfügungsdämpfung bzw. geringe Einfügungsverluste und geringe Herstellungskosten.

Aus der Publikation "Raluca Müller et. al. "Tunable Fabry-Perot surface micromachined Interferometer - experiments and modeling" in "mikrosystem Teochnologies; Micro And Nanosystems Information Storage and Processing Systemes", Bd. 12, Nr. 1-2, Seitein 91-97 ist ein Interferometer mit einer aus einer Implantationszone gebildeten Photodiode sowie einem bewegbaren Element benannt.

Die DE 10 2004 062 992 A1 offenbart einen Hochfrequenz-MEMS-Schalter gemäß dem Oberbegriff des Anspruchs 1. Dieser besteht aus einem hochresistiven Substrat, auf dessen einer Seite eine Elektrode als Masseelektrode vorgesehen ist. Auf der gegenüberliegenden Seite des Substrates ist eine Isolationsschicht angeordnet, auf der ein gebogenes Schaltelement mit dem einen Ende befestigt ist, während das gegenüberliegende freie Ende in einer vom Substrat weggebogenen Stellung angeordnet ist. Wird zwischen dem Schaltelement und der Masseelektrode eine Spannung angelegt, so bildet sich im wesentlichen zwischen dem Substrat unterhalb der Isolationsschicht und dem Schaltelement ein elektrisches Feld aus, welches den gebogenen Abschnitt des Schaltelements anzieht und dabei zur Substratoberfläche hin gerade biegt. Bei der Annäherung des biegbaren Schaltelements an die Isolationsschicht erfolgt eine kapazitive Koppelung zwischen dem Schaltelement und einem diesem dann gegenüberliegenden Signalleiter, was den eigentlichen Schaltvorgang darstellt. Dieser Signalleiter ist bei der beschriebenen vorbekannten Ausführung auf der Isolationsschicht angeordnet, dieser kann jedoch auch als unterhalb der Isolationsschicht ausgebildeter Implantationsbereich innerhalb des Substrates ausgebildet sein, der nach außen kontaktiert ist.

Die Schaltzeiten derartiger Hochfrequenz-MEMS-Schalter sind durch elektrische und mechanische Effekte limitiert. Für viele Anwendungen in Kommunikations- oder Radarsystemen werden kürzere Schaltzeiten wünschenswert. Dabei können die mechanischen Effekte aufgrund der Korrelation mit den Hochfrequenzeigenschaften der Schalter nicht beliebig verbessert werden. Die Schaltzeit ergibt sich dabei aus der Summe der mechanischen Schaltzeit und der elektrischen Schaltzeit, wobei letztere proportional ist zum Kehrwert aus dem Produkt des Zuleitungswiderstandes mit der Kapazität der MEMS-Struktur (1/ (R * C)).

Oft werden die geometrischen Abmessungen der HF-MEMS-Schalter und ihre Schaltelemente (Biegebalken) optimiert, um deren mechanische Schaltzeit zu verkürzen. Darüber hinaus können

Überspannungen (Aktuierungsspannungen, die deutlich über der Schaltspannung liegen) eingesetzt werden, um die Einschaltzeit weiter zu reduzieren, nicht jedoch die Ausschaltzeit. Die elektrische Schaltzeit bleibt aber von diesen Maßnahmen (nämlich der Optimierung der geometrischen Abmessungen der HF-MEMS-Schalter und Schaltelemente) unberührt. Nur die elektrische Einschaltzeit kann ebenfalls durch Überspannungen weiter verringert werden, was allerdings das Ansammeln von ungewollten Ladungsträgern an der Isolatoroberkante fördert (Stickingeffekt), welche den MEMS-Schalter unbrauchbar machen können. Da die Ladungsträger an die Unterseite der Isolationsschicht gebracht werden müssen, wird der für die elektrische Schaltzeit maßgebliche Widerstand der Zuleitung dominiert durch den Substratwiderstand und den Schottky-Kontakt auf der Substratrückseite. Typische Werte für diesen Widerstand liegen in der Größenordnung von 700 kΩ. Typische mechanische Schaltzeiten liegen im Bereich von 8 µs bis 100 µs. Diese variiert je nach angelegter Aktuierungsspannung. Ist diese im Vergleich zur Schaltspannung hoch, so sind die Schaltzeiten kurz, da der Biegebalken durch eine relativ große Kraft stark Richtung Substrat beschleunigt wird. 8 µs repräsentiert den Wert für eine hohe und 100 µs den Wert für eine niedrige Spannung.

Typische elektrische Schaltzeiten unter Berücksichtigung der Kapazitäten in der Größenordnung von 50 pF liegen im Bereich von 30 µs bis 90 µs. Auch die elektrische Schaltzeit schwankt für kleine und große Aktuierungsspannungen des Schalters.

Aus den Druckschriften US 2009/0174014 A1 und US 2008/0017489 A1 sind MEMS-Hochfrequenzschalter mit oberflächennahen Kontakten bekannt.

Die Verwendung von dotierten Halbleiterschichten unter einer Isolationsschicht auf einem hochresitiven Substrat als Kontaktelektrode ist in der Druckschrift von B. Pillans et al., "Schottky contact RF MEMS switch characterization", Proc. IEEE Int. Microw. Symp., 2007, S.379-382 offenbart. In der Druckschrift von J. Iannacci et al.: "A general purpose reconfigurable MEMS-based attenuator for Radio Frequency and microwave applications", EUROCON 2009, IEEE, 18-23 May 2009, S. 1197-1205 ist ferner ein MEMS-Hochfrequenzschalter mit einer durch Implantation dotierten Polysiliziumelektrode unter einer dünnen Isolationsschicht beschrieben.

Vergrabene Kontakte nahe der Oberfläche von Substraten von Hochfrequenzbauelementen sind aus der US 5 628 663 A bekannt. Auch die ohmsche Kontaktierung von vergrabenen, implantierten Elektroden ist bereits aus der US 2007/0215966 A1 bekannt.

Hiervon ausgehend liegt der Erfindung die Aufgabe zugrunde, einen Hochfrequenz-MEMS-Schalter gemäß dem Oberbegriff des Patentanspruchs 1 bereit zu stellen, der sich durch eine verkürzte Schaltzeit auszeichnet.

Erfindungsgemäß wird diese Aufgabe dadurch gelöst, dass im Substrat direkt unterhalb des Isolators mindestens eine Implantationszone ausgebildet ist, die durch eine Öffnung im Isolator mit der oberhalb des Isolators angeordneten Kontaktelektrode kontaktiert ist und ferner ohmschen Kontakt zum Substrat aufweist.

Vorteilhafte Weiterbildungen der Erfindung ergeben sich aus den Unteransprüchen.

Die Grundidee der Erfindung besteht darin, die Zuführung des Massepotentials nicht wie bisher von der Rückseite des Substrats sondern von der Oberseite durch eine Öffnung im Isolator durchzuführen und einen Implantationsbereich zur Herstellung eines ohmschen Kontaktes zum Substrat unterhalb des Isolators bereit zu stellen. Anstatt einer Kontaktierung des Substrats auf der Rückseite wird der Massekontakt also über die Vorderseite geführt. Durch das Einbringen mindestens einer Implantationszone mit ohmschen Kontakten zum hochresistiven Substrat neben oder unter dem Schaltelement werden die elektrischen Wege und damit die Zuleitungswiderstände und folglich auch die elektrische Schaltzeit verkürzt. Des Weiteren wird die in einer Polarität undefiniert hochohmige Schottkydiode zwischen Rückseitenkontakt und Substrat vermieden. Dadurch lässt sich der Widerstand der Zuleitung je nach Ausführung genau und reproduzierbar auf die jeweils gewünschte Größenordnung von z.B. 50 kΩ reduzieren, so dass nunmehr elektrische Schaltzeiten bei hohen Aktuierungsspannungen im Bereich von 2 bis 40 µs möglich sind. Der Einsatz der mindestens einen Implantationszone zum Massekontakt des Substrates von der "Vorderseite" verkürzt die elektrische Schaltzeit und damit die Gesamtschaltzeit deutlich. Damit wird das Anwendungsspektrum der HF-MEMS deutlich erweitert. Gemäß einer vorteilhaften Weiterbildung der Erfindung ist die mindestens eine Implantationszone gegenüber dem Schaltelement seitlich versetzt. Diese Anordnung hat den Vorteil weniger HF-Verlust zu verursachen, als eine Anordnung direkt unter dem Schaltelement selbst. Diese Anordnung verursacht jedoch einen höheren Widerstand im Gegensatz zu derjenigen, bei der die Implantation direkt unter dem Schalterelement angebracht wird.

Es können auch mehrere Implantationszonen vorgesehen werden, die an verschiedenen Positionen, beispielsweise beidseitig des Schaltelementes angeordnet sein können.

Die Implantationszone wird vorzugsweise mittels Ionenimplantation gebildet.

Wenn die Implantationszone direkt unterhalb des Schaltelements angeordnet ist, ergibt sich ein geringstmöglicher Zuleitungswiderstand in einer Größenordnung von ca. 50 kΩ möglich ist, wodurch sich kürzest mögliche Schaltzeiten ergeben.

Gemäß einer vorteilhaften Weiterbildung endet die Implantationszone vor dem beweglichen Ende des Schaltelementes, und zwar vor einem zweiten Implantationsbereich, der unterhalb des beweglichen Schaltelementes ausgebildet ist, um im Zusammenwirken mit dem bewegbaren Schaltelement den eigentlichen Schaltvorgang als kapazitive Kopplung auszuführen.

Die Implantationszone wird mittels einer Standardionenimplantation erzeugt, wobei die Dotierung so gewählt wird, dass sich ein ohmscher Kontakt mit dem Substrat ergibt. Diese ist vorzugsweise mindestens ca. 1 µm tief.

Die Erfindung wird nachfolgend anhand bevorzugter Ausführungsformen unter Bezugnahme auf die beigefügten Zeichnungen weiter erläutert. Gleiche Bezugszeichen bezeichnen dabei gleiche Teile. Dabei zeigt:
- Figur 1:: eine schematische Schnittansicht eines Hochfrequenz-MEMS-Schalters.
- Figur 2 bis 4:: Draufsichten dreier verschiedener Ausführungsformen von Hochfrequenz-MEMSSchaltern.

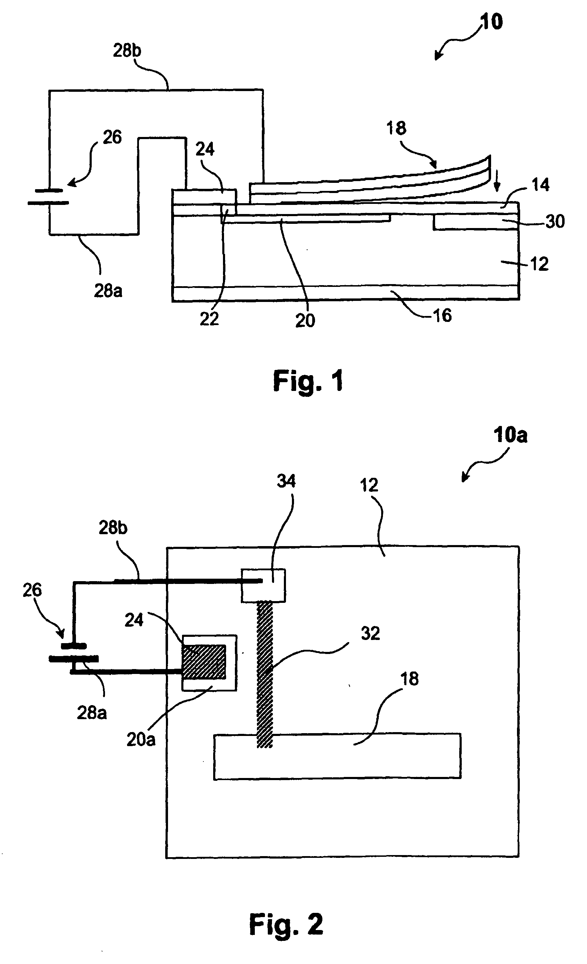

**Figur 1** zeigt eine schematische Schnittansicht eines Hochfrequenz-MEMS-Schalters **10,** der für Hochfrequenzanwendungen geeignet ist. Dieser umfasst ein hoch resistives Substrat **12,** das beispielsweise aus Silizium besteht. Auf dessen Vorderseite ist eine Isolationsschicht **14,** beispielsweise aus SiO₂ in einer Dicke von ca. 100 nm bis 500 nm vorgesehen. Auf der Rückseite des Substrat 12 ist ein Rückseitenkontakt **16** vorgesehen, über den herkömmlicherweise der Schalter **10** beschaltet wurde. Nunmehr dient dieser nur noch der HF-Übertragung mittels Mikrostreifenleitung.

Auf der Isolationsschicht **14** ist im Ruhezustand ein gebogenes Schaltelement **18** mit einem Ende befestigt, während das freie Ende von der Isolationsschicht **14** absteht.

Unterhalb der Isolationsschicht **14** erstreckt sich eine erste Implantationszone **20,** die über einen Durchbruch **22** in der Isolationsschicht **14** mit einem metallischen ersten Anschlusskontakt **24** elektrisch leitend verbunden ist.

Eine Spannungsquelle **26** ist über eine Leitung **28a** mit dem ersten Anschlusskontakt **24** und eine Leitung **28b** mit dem Schaltelement **18** verbunden.

Unterhalb des freien Endes des Schaltelement **18** befindet sich eine zweite Implantationszone **30,** die über eine nicht dargestellte Verbindung den Signalleiter der weiterführenden Mikrostreifenleitung kontaktiert und bei Annäherung des Schaltelements **18** zwischen diesem und der Implantationszone **30** eine kapazitive Kopplung gebildet wird.

Durch Aktivierung der Spannungsquelle **26** gelangen Ladungsträger einer Polarität in das Schaltelement **18** und solcher entgegengesetzter Polarität über die Leitung **28a** in die Implantationszone **20** und von dort in das Substrat **12** und bewirken eine elektrostatische Anziehung, welche das Schaltelement **18** damit in Richtung des Substrates **12** zieht und dabei streckt. Durch die Annäherung des Schaltelements **18** an die zweite Implantationszone **30** wird über eine kapazitive Kopplung der eigentliche Schaltvorgang bewirkt. Wenn die Spannungsquelle **26** wieder abgeschaltet wird, so entfällt die elektrostatische Anziehung und das Schaltelement **18** bewegt sich wieder in die gebogene Ruhestellung zurück, wodurch sich der Schalter wieder "öffnet", also die kapazitive Kopplung beendet wird.

**Figur 2** zeigt eine schematische Draufsicht einer ersten bevorzugten Ausführungsform eines Hochfrequenz-MEMS-Schalters **10a,** bei der die Implantationszone **20a** gegenüber dem Schaltelement **18** seitlich versetzt ist. Das Schaltelement **18** ist mittels eines widerstandsbehafteten Leiters **32** mit einem zweiten Anschlusskontakt **34** gekoppelt, der über die Leitung **28b** mit der Spannungsquelle **26** in Verbindung steht. Die zweite Implantationszone ist in diesen Figuren nicht dargestellt.

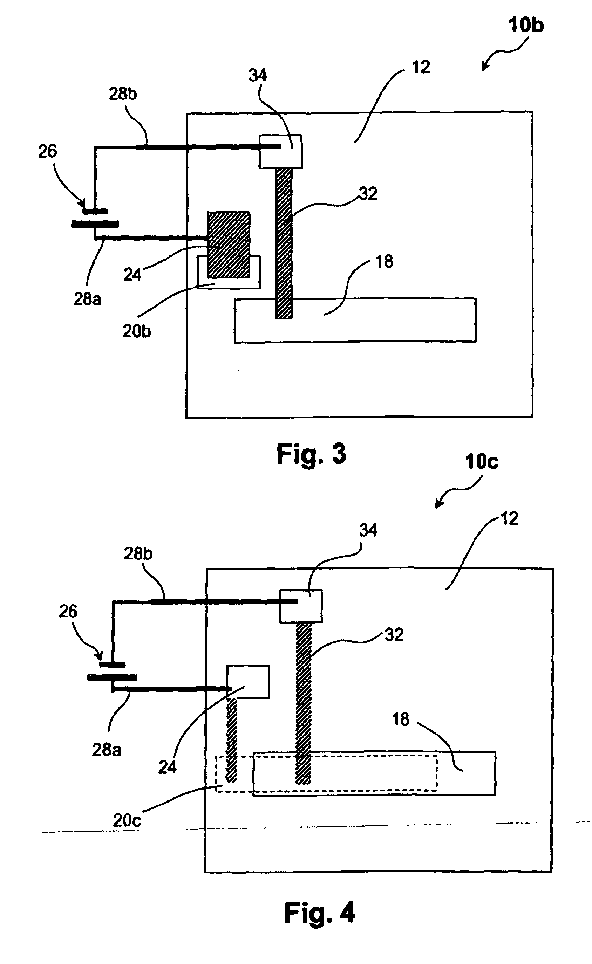

Die Ausführungsform gemäß **Figur 3** ist derjenigen von Figur 2 sehr ähnlich, nur liegt die Implantationszone 20b dem Schaltelement **18** näher als diejenige von Figur 1, wodurch der elektrische Widerstand damit geringer und die elektrische Schaltzeit kürzer ist als bei der Ausführungsform gemäß Figur 2. Diese Ausführung hat den Vorteil, dass im Gegensatz zu Figur 4 die HF-Verluste etwas geringer sind.

Bei der Ausführungsform gemäß **Figur 4** liegt die Implantationszone **20c** komplett unterhalb des Schaltelementes **18** und erstreckt sich über einen wesentlichen Teil dessen Länge, wodurch sich ein sehr geringer ohmscher Widerstand ergibt. Diese Ausführung hat den Vorteil, dass sich hiermit die kürzesten Schaltzeiten ergeben.

## Patentansprüche

1. Hochfrequenz-MEMS-Schalter (10) mit einem biegbaren Schaltelement (18), dessen festes Ende auf einem Isolator (14) angebracht ist, der auf einem hochresistiven Substrat vorgesehen ist, wobei das Substrat (12) ferner einen Signalleiter (30) umfasst, der mit dem bewegbarer Ende des Schaltelementes (18) in dessen unterer Endstellung eine kapazitive Kopplung ausbildet, ferner mit einer Kontaktelektrode (24) zur Zuführung von Ladungsträgern in das Substrat (12), wobei zwischen Schaltelement (18) und Substrat (12) ein elektrisches Feld zur Erzeugung einer elektrostatischen Biegekraft auf das Schaltelement (18) erzeugbar ist, **dadurch gekennzeichnet, dass** im Substrat (12) direkt unterhalb des Isolators (14) mindestens eine Implantationszone (20) ausgebildet ist, die durch eine Öffnung (22) im Isolator (14) mit der oberhalb des Isolators (14) angeordneten Kontaktelektrode (24) kontaktiert ist und ferner ohmschen Kontakt zum Substrat (12) aufweist.

2. Hochfrequenz-MEMS-Schalter nach Anspruch 1, **dadurch gekennzeichnet, dass** die Implantationszone (20) gegenüber dem Schaltelement (18) seitlich versetzt ist.

3. Hochfrequenz-MEMS-Schalter nach Anspruch 2, **dadurch gekennzeichnet, dass** die Implantationszone (20) vor dem beweglichen Ende des Schaltelementes (18) endet und unterhalb des freien Endes des Schaltelementes (18) der Signalleiter als zweiter Implantationsbereich (30) ausgebildet ist.

4. Hochfrequenz-MEMS-Schalter nach einem der vorherigen Ansprüche, **dadurch gekennzeichnet, dass** mehrere Implantationszonen (20) vorgesehen sind.

## Claims

1. High-frequency MEMS switch (10) comprising a flexible switching element (18), the fixed end of which is mounted on an insulator (14) which is provided on a highly resistive substrate, wherein the substrate (12) further comprises a signal conductor (30) which forms a capacitive coupling with the moveable end of the switching element (18) in the lower end position thereof, and further comprising a contact electrode (24) for feeding charge carriers into the substrate (12), wherein an electric field can be generated between switching element (18) and substrate (12) for producing an electrostatic bending force on the switching element (18), **characterized in that** in the substrate (12) directly underneath the insulator (14), at least one implantation zone (20) is formed that is contacted with the contact electrode (24) arranged above the insulator (14) through an opening (22) in the insulator (14) and that further exhibits ohmic contact with the substrate (12).

2. High-frequency MEMS switch according to Claim 1, **characterized in that** the implantation zone (20) is laterally offset relative to the switching element (18).

3. High-frequency MEMS switch according to Claim 2, **characterized in that** the implantation zone (20) ends before the moveable end of the switching element (18), and underneath the free end of the switching element (18) the signal conductor is implemented as a second implantation region (30).

4. High-frequency MEMS switch according to any one of the previous claims, **characterized in that** a plurality of implantation zones (20) are provided.

## Revendications

1. Commutateur Haute fréquence-MEMS (10) avec un élément de commutation flexible (18), dont l'extrémité fixe est montée sur un isolateur (14) qui est prévu sur un substrat hautement résistif, pour lequel le substrat (12) comprend en outre un conducteur de signaux (30) qui, avec l'extrémité mobile de l'élément de commutation (18) dans la position de fin de course inférieure de celui-ci, constitue un accouplement capacitif, en plus avec une électrode de contact (24) pour amener des porteurs de charge dans le substrat (12), pour lequel un champ électrique destiné à générer un effort de flexion électrostatique entre l'élément de commutation (18) et le substrat (12) peut être produit sur l'élément de commutation (18), **caractérisé en ce qu'**au moins une zone d'implantation (20) est constituée dans le substrat (12) directement sous l'isolateur (14), qui est mise en contact par une ouverture (22) dans l'isolateur (14) avec l'électrode de contact (24) disposée au-dessus de l'isolateur (14) et comporte en plus un contact ohmique avec le substrat (12).

2. Commutateur Haute fréquence-MEMS selon la revendication 1 **caractérisé en ce que** la zone d'implantation (20) est latéralement décalée par rapport à l'élément de commutation (18).

3. Commutateur Haute fréquence-MEMS selon la revendication 2 **caractérisé en ce que** la zone d'implantation (20) se termine avant l'extrémité mobile de l'élément de commutation (18) et en-dessous de l'extrémité libre de l'élément de commutation (18) le conducteur de signaux est constitué comme deuxième zone d'implantation (30).

4. Commutateur Haute fréquence-MEMS selon l'une quelconque des revendications précédentes **caractérisé en ce que** plusieurs zones d'implantation (20) sont prévues.
